# FASCICULE DE BREVET EUROPEEN

(11) **EP 2 577 723 B1**
(45) Date de publication et mention de la délivrance du brevet: **02.07.2014**
(21) Numéro de dépôt: 11724393.1
(22) Date de dépôt: 25.05.2011
(51) Int. Cl.: H01L 21/768, H01L 21/033

(54) **PROCEDE DE LITHOGRAPHIE POUR LA REALISATION DE RESEAUX DE CONDUCTEURS RELIES PAR DES VIAS**
LITHOGRAFISCHES VERFAHREN ZUR HERSTELLUNG VON NETZWERKEN AUS ANHAND VON DURCHKONTAKTIERUNGEN VERBUNDENEN LEITERN
LITHOGRAPHY METHOD FOR MAKING NETWORKS OF CONDUCTORS CONNECTED BY VIAS

(30) Priorité: 01.06.2010 FR 1002307
(43) Date de publication de la demande: 10.04.2013
(73) Titulaire: Commissariat à l'Énergie Atomique et aux Énergies Alternatives, 75015 Paris (FR)
(72) Inventeur: BELLEDENT, Jérôme, F-38920 Crolles (FR); PAIN, Laurent, F-38500 St Nicolas de Macherin (FR); BARNOLA, Sébastien, F-38190 Villard-Bonnot (FR)
(74) Mandataire: Guérin, Michel
(86) Numéro de dépôt international: PCT/EP2011/058600
(87) Numéro de publication internationale: WO 2011/151244

(56) Documents cités:
- WO-A2-2008/033695
- US-A1- 2006 046 201
- US-A1- 2006 046 422
- US-A1- 2006 240 361

## Description

L'invention concerne la lithographie pour la gravure de motifs très denses sur un substrat, et plus précisément pour la réalisation de réseaux de conducteurs dans des circuits intégrés de microélectronique.

Par motifs denses, on entend des motifs dont certains éléments sont de très petite largeur et séparés par des intervalles de très petite largeur. Avec la photolithographie, on expose une couche sensible, par exemple à travers un masque, à un faisceau par exemple ultraviolet, typiquement à une longueur d'onde de 193 nanomètres. La densité des motifs, c'est-à-dire la résolution qu'on peut atteindre dans la gravure du motif, est liée à plusieurs paramètres mais elle dépend d'abord de la longueur d'onde utilisée ; plus elle est courte plus la densité est grande. On peut augmenter la densité des motifs en utilisant l'extrême ultraviolet (notamment à 13,5 nanomètres) ; on peut l'augmenter aussi en utilisant une exposition par un faisceau électronique de diamètre très étroit, mais le processus de gravure est beaucoup plus lent car l'écriture d'un motif se fait point par point et non à travers un masque global définissant les motifs ; d'autre part, les faisceaux électroniques étroits peuvent engendrer des phénomènes de dispersion et rétrodiffusion d'électrons nuisant à la résolution.

Dans le domaine des mémoires, on a déjà proposé, pour augmenter la densité possible des lignes nécessaires pour réaliser ces mémoires, de réaliser les étapes suivantes :
- formation d'une couche sacrificielle sur un substrat,
- gravure de la couche sacrificielle selon des premières bandes,
- formation d'espaceurs le long de tous les bords de la couche sacrificielle ainsi gravée,
- enlèvement de la couche sacrificielle pour ne laisser subsister que les espaceurs formant les lignes denses recherchées.

US2006/046201 divulgue un procédé de lithographie avec la formation d'une couche sacrificielle qui est gravée selon un motif suivi par la formation d'espaceurs le long des bords de la couche sacrificielle qui est ensuite enlevée.

L'invention propose une amélioration de ce type de procédé, adaptée à la fabrication de réseaux de conducteurs superposés, séparés par une couche isolante et reliés par des vias conducteurs à travers cette couche isolante.

Un problème se pose alors qui est l'alignement des vias par rapport à l'un au moins des deux réseaux conducteurs et l'invention apporte une solution en utilisant des étapes communes pour la réalisation du deuxième réseau conducteur et des vias, et en utilisant pour les vias un alignement par des espaceurs qui servent à la définition des conducteurs-, de sorte que les vias sont parfaitement alignés avec le deuxième réseau même lorsque celui-ci est très dense.

Selon l'invention, on effectue des étapes de formation d'espaceurs à partir d'une couche sacrificielle sur un substrat qui comporte déjà un premier réseau de conducteurs recouvert par un matériau isolant et par une couche minérale (masque dur) et on grave la couche minérale selon le motif de régions libres définies par les espaceurs ; ce motif est celui des conducteurs du deuxième réseau. Puis, on effectue deux gravures successives du matériau isolant du substrat, sur deux profondeurs successives, l'une définissant la profondeur des conducteurs du deuxième réseau, l'autre définissant un complément de profondeur nécessaire aux endroits souhaités pour les vias. L'une des gravures est définie par le masque dur et elle correspond aux emplacements des conducteurs du deuxième réseau ; l'autre est définie à la fois par des ouvertures dans une résine de lithographie et par les mêmes espaceurs qui ont servi à graver le masque dur, et elle correspond aux emplacements des vias. L'ordre des gravures est indifférent. Enfin, après les deux gravures, les régions gravées dans le matériau isolant du substrat sont remplies d'un matériau conducteur qui forme en même temps les conducteurs et les vias.

En résumé, l'invention propose un procédé de lithographie pour réaliser dans un substrat deux réseaux de conducteurs superposés séparés par une couche isolante, avec des vias conducteurs dans la couche isolante pour relier des conducteurs du premier réseau aux conducteurs du deuxième réseau à des emplacements où ces conducteurs se croisent, le procédé comportant :
- la formation des conducteurs du premier réseau sur le substrat,
- le dépôt d'un matériau isolant recouvrant les conducteurs du premier réseau,
- le dépôt d'une couche de masque minéral sur le matériau isolant,
- le dépôt d'une couche sacrificielle et la gravure de cette couche selon un premier motif partiel,
- la formation d'espaceurs sur les bords des éléments de la couche sacrificielle ainsi gravée, les espaceurs laissant libres des zones définissant un deuxième motif partiel,
- l'élimination de la couche sacrificielle pour ne laisser subsister que les espaceurs,
- la gravure de la couche de masque minéral protégée par les espaceurs, cette gravure définissant les emplacements des conducteurs du deuxième réseau,
- une première gravure du matériau isolant sur une première profondeur,
- une deuxième gravure du matériau isolant sur une deuxième profondeur,
- l'une des gravures étant définie par la configuration du masque minéral et correspondant aux emplacements des conducteurs du deuxième réseau, et l'autre gravure étant délimitée à la fois par des ouvertures formées dans une couche gravée par lithographie et par le deuxième motif partiel défini par les espaceurs, les ouvertures définissant les emplacements de vias conducteurs et étant délimitées au moins sur deux bords opposés par des espaceurs,
- enfin le remplissage des régions creusées dans le matériau isolant, par un matériau conducteur affleurant à la surface du matériau sans déborder des régions creusées, ce matériau constituant à la fois les conducteurs du deuxième réseau et les vias conducteurs.

Le matériau isolant est de préférence un matériau diélectrique à faible constante diélectrique déposé sur une tranche de silicium ; le matériau conducteur est de préférence du cuivre affleurant à la surface du matériau isolant sans déborder des régions creusées.

La gravure délimitée à l'aide de la couche de résine est de préférence une gravure par faisceau électronique, et la couche de résine a de préférence une épaisseur inférieure à la hauteur des espaceurs.

Entre l'étape d'élimination de la couche sacrificielle et la gravure de la couche de masque minéral on prévoit de préférence une étape de lithographie supplémentaire, de préférence par faisceau électronique, pour protéger de la gravure des régions supplémentaires autres que les emplacements des espaceurs. La- couche sensible utilisée lors de cette étape de lithographie a de préférence une épaisseur inférieure ou égale à la hauteur des espaceurs.

D'autres caractéristiques et avantages de l'invention apparaîtront à la lecture de la description détaillée qui suit et qui est faite en référence aux dessins annexés dans lesquels :
- la figure 1 représente un exemple schématique de double réseau de conducteurs qu'on souhaite réaliser sur un substrat, avec des vias entre les conducteurs des deux réseaux ;
- les figures 2 à 8 représentent les premières étapes de mise en oeuvre de l'invention ;
- les figures 9 à 15 représentent la suite du procédé dans une première variante ;
- les figures 16 à 19 représentent la suite du procédé dans une deuxième variante.

L'invention va être décrite à propos de la réalisation d'une structure dite « double damascène » comprenant un premier réseau de conducteurs enterrés dans un substrat isolant et un deuxième réseau de conducteurs superposé au premier et connecté à ce dernier à travers des vias conducteurs ouverts dans le substrat, les deux réseaux étant dessinés selon des motifs denses.

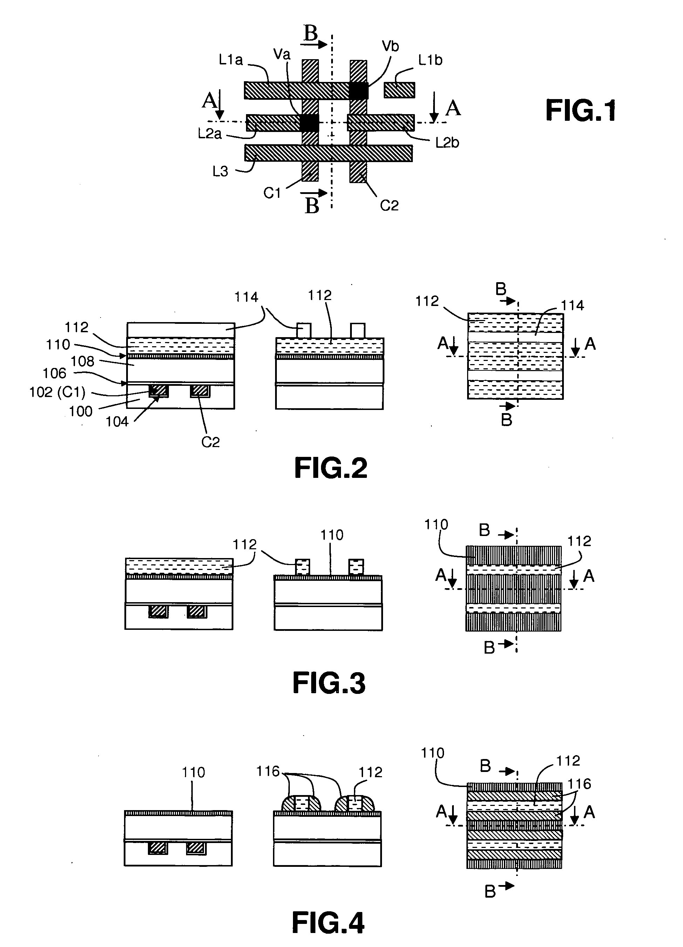

La figure 1 représente en vue de dessus la structure qu'on veut réaliser ; un réseau inférieur comprend des conducteurs en bandes verticales ; un réseau supérieur comprend des conducteurs en bandes horizontales ; deux vias de contact sont représentés à l'endroit des croisements entre un conducteur vertical et un conducteur horizontal ; les autres croisements sont des croisements sans contact.

Le premier réseau (inférieur) comporte dans cet exemple deux conducteurs C1 et C2 orientés verticalement sur le dessin et le deuxième réseau, supérieur, comporte trois lignes parallèles de conducteurs orientés horizontalement sur le dessin ; deux des lignes sont interrompues à un endroit, c'est-à-dire divisées chacune en deux tronçons séparés par un intervalle ; les tronçons sont L1a, L1b pour la première ligne, L2a, L2b pour la deuxième ligne. La troisième ligne L3 est continue. Les conducteurs horizontaux et verticaux se croisent et deux vias de connexion électrique Va et Vb sont prévus, respectivement au croisement du tronçon L1a et du conducteur C2, et au croisement du tronçon L2a et du conducteur C1. Les autres croisements sont des croisements sans vias de connexion. Les espacements entre conducteurs ou entre tronçons peuvent être aussi petits que 20 à 30 nanomètres.

Le premier réseau de conducteurs peut avoir été fait par n'importe quel procédé et on va décrire essentiellement la fabrication du deuxième réseau et des vias de connexion. Cette fabrication est décrite en référence aux figures 2 à 15 qui illustrent les différentes étapes du procédé. Sur chaque figure on a représenté trois éléments de dessin qui sont respectivement : à droite une vue de dessus de la structure, à gauche une coupe de la structure selon la ligne AA de la vue de dessus, et au centre une coupe selon la ligne BB de la vue de dessus. Pour une meilleure lisibilité des figures, on n'a représenté sur les dessins en coupe que les éléments situés dans le plan de coupe, et on n'a pas représenté sur les vues de dessus les conducteurs enterrés du premier réseau (qui sont visibles sur la figure 1).

On considère donc (figure 2) qu'on part d'un substrat 100 en silicium par exemple dans lequel ont été formés des conducteurs enterrés 102, par exemple des conducteurs de cuivre noyés dans des tranchées dont les flancs sont isolés par du nitrure de tantale 104. Ces conducteurs forment le premier réseau. Le substrat et ses conducteurs enterrés sont recouverts d'une couche isolante ou couche diélectrique 108 qui assure l'isolation entre les deux réseaux de conducteurs ; une couche d'adaptation isolante 106 peut être prévue entre le substrat 100 et la couche diélectrique 108. On formera à travers la couche diélectrique 108 (et la couche 106) des vias aux endroits où un conducteur du deuxième réseau croise un conducteur du premier réseau et doit être relié à ce dernier. La couche diélectrique est de préférence une couche à faible constante diélectrique (low-k dielectric en anglais), telle que de l'oxyde de silicium dopé au carbone ou au fluor.

La couche diélectrique est recouverte d'une couche superficielle 110 formant masque de gravure pour le deuxième réseau de conducteurs et pour les vias conducteurs. Le masque de gravure est un masque minéral (par opposition aux masques de résine qui sont des masques en matériau organique) ; il peut être en nitrure de titane.

Une couche sacrificielle 112, qui peut être en carbone déposé à la tournette (spin-on carbon), recouvre la couche de nitrure 110. Elle sera ultérieurement enlevée.

Une couche de résine 114 sensible aux ultraviolets est déposée et est gravée par photolithographie ultraviolette pour définir un premier motif de résine ; ce motif est un premier motif partiel servant à la définition du deuxième réseau de conducteurs. La résine une fois développée définit les emplacements de protection de la couche sacrificielle. Une couche intermédiaire antireflets, non représentée, facilitant la photolithographie peut être interposée entre la couche sacrificielle 112 et la couche de résine 114.

La couche sacrificielle est attaquée là où elle n'est pas protégée par la résine, et la résine est enlevée (figure 3) ; on aboutit à une structure comprenant le premier motif partiel de régions libres non recouvertes par des éléments de la couche sacrificielle 112.

On forme alors les espaceurs 116 le long des bords des tronçons de la couche sacrificielle (figure 4). Les espaceurs peuvent être en oxyde de silicium ou nitrure de silicium ou un oxynitrure de silicium SiOxNy, ou encore un matériau organique. Les espaceurs peuvent être formés par un dépôt conforme d'une couche, suivie d'une gravure anisotrope verticale sur une épaisseur limitée, mettant à nu la surface supérieure de la couche sacrificielle et mettant à nu en même temps la couche 110, mais laissant subsister des portions le long de tous les flancs des éléments de la couche sacrificielle. Ces portions subsistent du fait de la surépaisseur de couche qui s'accumule le long de ces flancs lors du dépôt conforme ; elles constituent les espaceurs 116.

Les zones non recouvertes par les espaceurs et la couche sacrificielle définissent un deuxième motif partiel, déduit directement du premier puisqu'il n'y a pas eu d'autre opération de photolithographie après la définition du premier motif partiel.

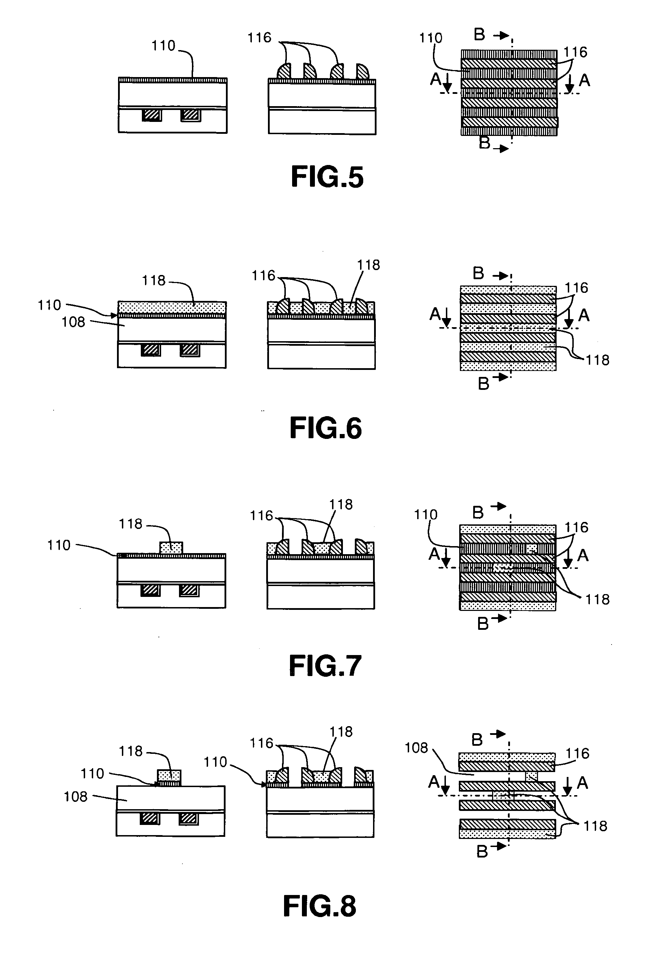

A ce stade, on élimine la couche sacrificielle 112, ne laissant subsister que les espaceurs 116 (figure 5). Le motif de régions libres est alors une combinaison des premier et deuxième motifs partiels.

On dépose alors (figure 6) une couche 118 qui, avantageusement, est une couche sensible à un faisceau photonique ou ionique ou électronique, sur une épaisseur inférieure à la hauteur des espaceurs (qui est elle-même la hauteur de la couche sacrificielle qui a maintenant disparu). S'il est nécessaire de faire une gravure pleine plaque de la couche sensible118 pour en réduire la hauteur jusqu'à ce qu'elle ne dépasse plus des espaceurs, on fait cette gravure à ce stade.

On effectue ensuite la gravure de la couche 118 par un rayonnement adapté. La couche sensible développée définit un troisième motif partiel (figure 7). Cette opération de lithographie est utilisée pour compléter la définition du motif de conducteurs du deuxième réseau, et plus précisément ici la définition des interruptions entre les tronçons de lignes, L1a, L1b par exemple : les interruptions sont masquées par la couche sensible 118.

En variante, la couche 118 pourrait être composée d'une couche inférieure non sensible, d'épaisseur inférieure à la hauteur des espaceurs, recouverte par une couche sensible à un rayonnement. La couche sensible définit un motif dans la couche non sensible et la couche non sensible peut alors servir de masque de lithographie pour la couche de nitrure 110.

Avantageusement, la couche sensible est gravée par un faisceau électronique.

Si la gravure de la couche sensible est faite par un rayonnement optique, ultraviolet par exemple, alors l'indice optique de la couche qui est située entre les espaceurs est de préférence sensiblement égal à celui des espaceurs (typiquement avec un écart de moins de 1%).

Après cette opération, il subsiste sur le substrat un motif final de régions libres qui ne sont masquées ni par les espaceurs ni par la couche sensible 118 ; ce motif est une combinaison des premier, deuxième et troisième motifs partiels. Il constitue le motif de conducteurs du deuxième réseau, incluant les emplacements de vias conducteurs.

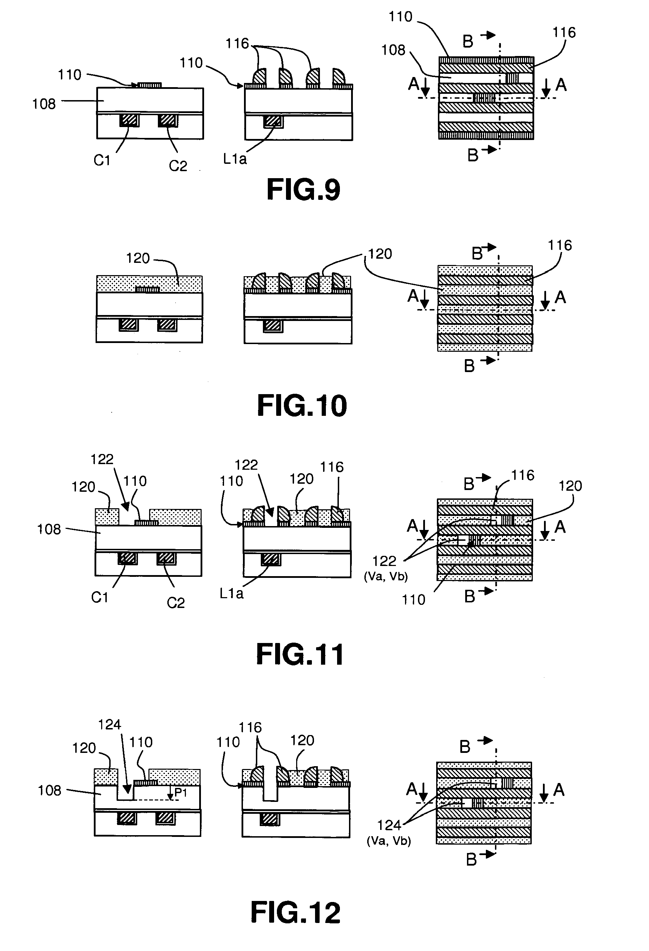

On attaque alors la couche de masque de gravure 110 là où elle n'est recouverte ni par la couche sensible ni par les espaceurs, pour y reporter le motif final (figure 8) ; le masque correspond alors au motif de conducteurs du deuxième réseau. Enfin, on enlève la couche sensible 118 (figure 9).

On fera attention que sur les figures 9 à 19 la ligne de coupe verticale R-R n'est pas située au même endroit que sur les figures précédentes : elle passe maintenant à travers le via Va situé en haut à droite sur la figure 1 (les vias ne sont pas encore définis à ce stade).

Pour définir les vias, on va utiliser une nouvelle couche avantageusement sensible à un rayonnement photonique ou ionique ou électronique, et là encore, l'épaisseur de cette couche est plus faible que la hauteur des espaceurs 116. La couche, qu'on appellera "couche sensible" pour simplifier, peut, comme précédemment, être composée soit d'une unique couche sensible soit d'une superposition de deux couches : une couche inférieure non sensible, d'épaisseur inférieure à la hauteur des espaceurs, recouverte par une couche supérieure sensible à un rayonnement ; dans ce cas, la couche supérieure sensible sert à définir un motif dans la couche non sensible et la couche non sensible peut servir de masque de gravure pour les vias.

Après exposition de la couche sensible par le faisceau de rayonnement et après développement, les parties de la couche sensible unique, ou de la couche inférieure non sensible, qui subsistent masquent les zones voulues. L'ensemble de cette couche définie par lithographie et des espaceurs précédemment formés définit le motif de vias qu'on veut réaliser.

Il est possible de déposer cette couche sensible simple ou double soit immédiatement après avoir enlevé la couche 118 soit après avoir préalablement gravé le substrat sur une partie de sa profondeur. On va d'abord décrire en détail le cas où on dépose immédiatement la nouvelle couche sensible, et on décrira ensuite la possibilité de ne la déposer qu'ultérieurement. On supposera pour simplifier que la couche sensible est unique.

On dépose donc une nouvelle couche sensible 120 (figure 10) sur une épaisseur inférieure à la hauteur des espaceurs.

Avantageusement, on utilise là encore comme couche sensible 120 une résine sensible à un faisceau électronique.

Dans le cas de résines sensibles à un rayonnement photonique, pour photolithographier la couche située entre les espaceurs (dont une dimension est inférieure à la longueur d'onde), on choisira de préférence pour les espaceurs et la couche déposée entre les espaceurs des matériaux d'indices sensiblement égaux (typiquement avec un écart de moins de 1 %).

On ouvre dans la couche sensible des ouvertures 122 selon un motif qui sert à délimiter les vias conducteurs à réaliser (figure 11) ; les ouvertures 122 sont formées à l'emplacement de croisements de conducteurs des deux réseaux, là où des contacts doivent être établis entre deux conducteurs qui se croisent. La gravure de la couche sensible est faite par un faisceau d'électrons. Sa résolution est améliorée du fait de la hauteur de couche sensible inférieure à la hauteur des espaceurs, et ceci encore mieux dans le cas où les espaceurs sont en matériaux relativement lourds susceptibles de mieux absorber les électrons dispersés latéralement lors de l'exposition au faisceau électronique.

Le motif de gravure des ouvertures 122 de la couche sensible peut déborder en partie sur des zones du masque de gravure 110 (voir sur la partie gauche de la figure 11) ; dans ce cas c'est le masque de gravure qui définira le bord des vias ; à d'autres endroits (voir encore la partie gauche de la figure 11), le bord de la couche sensible repose directement sur la couche diélectrique 108 et dans ce cas c'est la couche sensible qui définit le bord du via ; enfin, à d'autres endroits encore et sur au moins deux bords des vias, le bord de la couche sensible s'arrête sur des espaceurs et dans ce cas ce sont les espaceurs qui définissent les bords des vias (voir la partie centrale de la figure 11 le via au-dessus d'un conducteur du premier réseau).

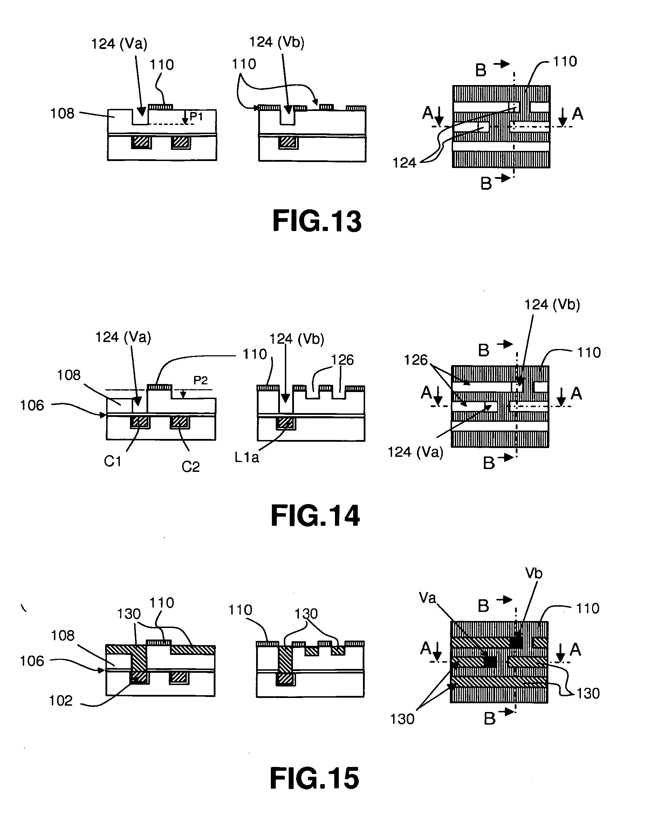

On grave alors des vias 124 dans la couche diélectrique 108 sur une première profondeur P1, inférieure à l'épaisseur de la couche 108, aux emplacements où la couche diélectrique n'est protégée ni par le masque de nitrure 110 ni par la couche sensible 120 (figure 12). Puis on enlève la couche sensible et les espaceurs (figure 13).

On continue la gravure de la couche diélectrique sur une deuxième profondeur P2 (figure 14) ; la gravure est définie cette fois seulement par le masque de nitrure 110 qui correspond exactement au motif de conducteurs du deuxième réseau ; la profondeur P2 correspond à l'épaisseur souhaitée pour les conducteurs du deuxième réseau ; là où il y a les vias 124, la gravure cumule les deux profondeurs P1 et P2 et la somme des profondeurs est telle que les vias atteignent le premier réseau de conducteurs ; la profondeur P1 est donc le complément de profondeur de gravure nécessaire pour atteindre les conducteurs du premier réseau.

Si une couche d'adaptation 106 est prévue dans la structure, elle est éliminée dans le fond des vias à ce stade pour dénuder les conducteurs du premier réseau au fond des vias. On dépose alors du métal conducteur 130 dans les ouvertures gravées dans la couche 108, y compris au fond des vias. Ce métal forme le deuxième réseau conducteur ainsi que les vias entre les deux réseaux (figure 15).

Le métal conducteur peut être du cuivre, qui est ultérieurement arasé pour ne pas déborder de ces emplacements creusés. Le dépôt de cuivre selon ce procédé damascène peut comprendre des étapes telles qu'un dépôt préalable de nitrure de tantale au fond des ouvertures gravées dans la couche 108. Ces étapes ne sont pas détaillées.

Le masque de nitrure est enlevé en fin de traitement.

La structure de double réseau de conducteurs à ce stade est bien celle que l'on voulait et qui est représentée à la figure 1.

Comme on l'a dit ci-dessus, on peut inverser l'ordre des gravures de la couche diélectrique 108 et effectuer la première étape de gravure avant de déposer la nouvelle couche 120 sensible au faisceau électronique. Cela revient globalement à exécuter l'étape de la figure 14 avant les étapes des figures 10 à 12. On inverse donc l'ordre de creusement des profondeurs P1 et P2 : P2 devient la première profondeur creusée pour réaliser les conducteurs, P1 devient la deuxième profondeur creusée pour réaliser les vias.

Par conséquent, après la gravure du masque minéral 110 (figure 8), on creuse le matériau isolant du substrat dans les régions qui ne sont pas recouvertes par le masque minéral, sur une première profondeur (qu'on appeler P2 : c'est la profondeur nécessaire pour réaliser les conducteurs du deuxième réseau) ; puis on dépose la nouvelle couche 120 sensible à un faisceau électronique sur une épaisseur inférieure ou égale à la hauteur des espaceurs, on grave cette couche sensible au moyen d'un faisceau électronique, on creuse le matériau isolant du substrat sur une deuxième profondeur (qu'on peut appeler P1) là où il n'est pas recouvert par la couche sensible ou le masque, on élimine la couche sensible et les espaceurs, et enfin on remplit avec un métal conducteur les emplacements creusés dans le matériau isolant.

La somme des profondeurs P1+P2 est la profondeur du premier réseau de conducteurs.

Les emplacements gravés dans le matériau isolant du substrat sont remplis de métal conducteur, et parmi ces emplacements, ceux qui sont creusés sur la première profondeur uniquement (P2) constituent un deuxième réseau de conducteurs, et ceux qui sont creusés sur la somme de la première (P2) et la deuxième profondeur (P1) constituent des vias de connexion entre le premier réseau et le deuxième réseau.

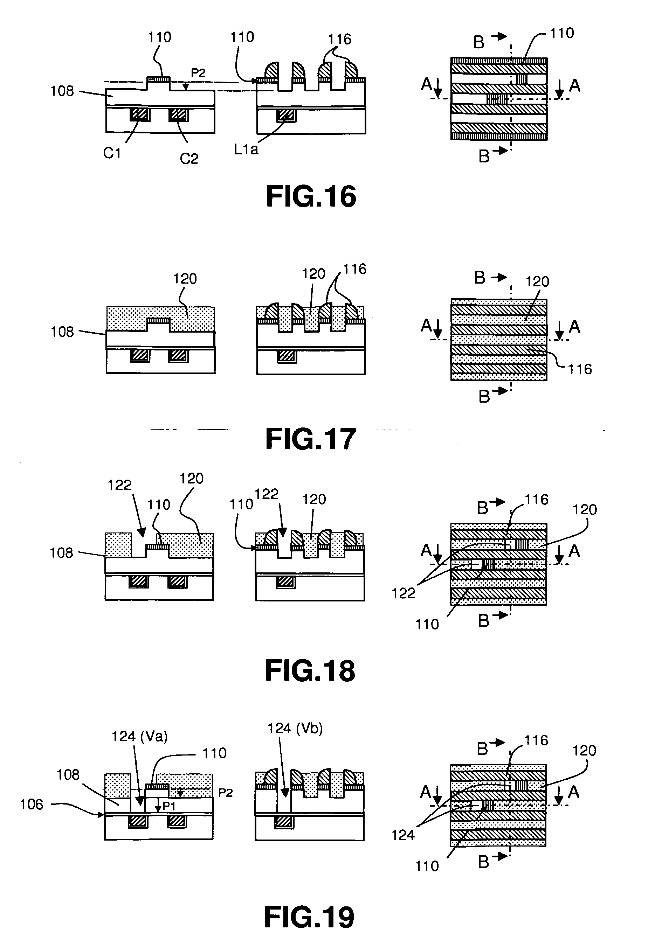

Par conséquent, après l'étape de la figure 9, on effectue dans ce cas la succession d'étapes des figures 16 à 19 qui se substitue à la succession d'étapes des figures 10 à 14 de la réalisation précédente.

Sur la figure 16 : après la constitution du masque de nitrure recouvert d'espaceurs, visible à la figure 9, on effectue une première gravure de la couche isolante 108 sur la profondeur P2.

Puis on dépose une couche 120 sensible à un faisceau électronique en vue de la lithographie des vias conducteurs (figure 17).

On expose la couche 120 à un faisceau électronique selon un motif d'ouvertures 122 permettant de définir les vias, avec les mêmes remarques qui ont été faites à propos de la figure 11 concernant la délimitation de ces ouvertures 122 dans la couche sensible (figure 18).

On effectue alors la deuxième gravure de la couche isolante 108, là où elle n'est pas protégée par le nitrure, la couche sensible ou les espaceurs ; l'attaque est faite sur une profondeur P1 qui vient s'ajouter, uniquement dans les vias 124 à la profondeur P2 (figure 19).

On élimine la couche 106 éventuellement présente dans le fond des vias, mettant à nu les conducteurs du premier réseau au fond des vias. On élimine ensuite la couche sensible 120 et les espaceurs 116.

Enfin, on dépose un matériau conducteur comme cela a été expliqué en référence à la figure 15, par un procédé damascène, pour aboutir à la même structure qu'à la figure 15, puis on enlève le masque de nitrure 110.

## Revendications

1. Procédé de lithographie pour réaliser dans un substrat deux réseaux de conducteurs superposés séparés par une couche isolante (108), avec des vias conducteurs (Va, Vb) dans la couche isolante pour relier des conducteurs du premier réseau aux conducteurs du deuxième réseau à des emplacements où ces conducteurs se croisent, le procédé comportant :
- la formation des conducteurs (102) du premier réseau sur le substrat,
- le dépôt d'un matériau isolant recouvrant les conducteurs du premier réseau et formant la couche isolante (108),
- le dépôt d'une couche de masque minéral (110) sur le matériau isolant,
- le dépôt d'une couche sacrificielle (112) et la gravure de cette couche selon un premier motif partiel,
- la formation d'espaceurs (116) sur les bords des éléments de la couche sacrificielle ainsi gravée, les espaceurs laissant libres des zones définissant un deuxième motif partiel,
- l'élimination de la couche sacrificielle (112) pour ne laisser subsister que les espaceurs,
- la gravure de la couche de masque minéral là où elle n'est pas protégée par les espaceurs, cette gravure définissant les emplacements des conducteurs du deuxième réseau,
- une première gravure du matériau isolant sur une première profondeur,
- une deuxième gravure du matériau isolant sur une deuxième profondeur,
- l'une des gravures étant définie par la configuration du masque minéral (110) et correspondant aux emplacements des conducteurs du deuxième réseau, et l'autre gravure étant délimitée à la fois par des ouvertures (122) formées dans une couche gravée par lithographie (120) et par le deuxième motif partiel défini par les espaceurs (116), les ouvertures définissant les emplacements de vias conducteurs et étant délimitées au moins sur deux bords opposés par des espaceurs,
- le remplissage des régions creusées dans le matériau isolant, par un matériau conducteur (130) affleurant à la surface du matériau sans déborder des régions creusées, ce matériau constituant à la fois les conducteurs du deuxième réseau et les vias conducteurs.

2. Procédé selon la revendication 1, **caractérisé en ce que** la couche gravée par lithographie (120) est déposée avant les deux gravures du matériau isolant, elle est exposée selon un motif d'ouvertures, après quoi la première gravure du matériau isolant est effectuée pour définir les emplacements de vias conducteurs, la couche gravée par lithographie est éliminée, et la deuxième gravure est effectuée pour définir les emplacements de conducteurs du deuxième réseau.

3. Procédé selon la revendication 2, **caractérisé en ce que** les espaceurs sont éliminés avant la deuxième gravure.

4. Procédé selon la revendication 1, **caractérisé en ce que** la première gravure du matériau isolant est effectuée après la gravure du masque minéral pour définir les emplacements des conducteurs du deuxième réseau, puis la couche gravée par lithographie (120) est déposée et gravée selon un motif d'ouvertures (122), puis la deuxième gravure du matériau isolant est effectuée pour définir les emplacements des vias conducteurs, après quoi la résine et les espaceurs sont éliminés.

5. Procédé selon l'une des revendications 1 à 4, **caractérisé en ce que** la couche gravée par lithographie est une résine sensible à un rayonnement ionique ou électronique ou photonique et son épaisseur est inférieure à la hauteur des espaceurs.

6. Procédé selon la revendication 5, **caractérisé en ce que** la couche gravée par lithographie est composée de la superposition d'une couche non sensible à un rayonnement ionique ou électronique ou photonique et d'une couche sensible à un rayonnement ionique ou électronique ou photonique, la couche non sensible ayant une épaisseur inférieure à la hauteur des espaceurs.

7. Procédé selon l'une des revendications 1 à 6, **caractérisé en ce que** le matériau isolant est un matériau diélectrique à faible constante diélectrique déposé sur une tranche de silicium.

8. Procédé selon l'une des revendications 1 à 7, **caractérisé en ce que** le matériau conducteur (130) est du cuivre affleurant à la surface du matériau isolant sans déborder des régions creusées.

9. Procédé selon l'une des revendications 1 à 8, **caractérisé en ce que**, entre l'étape d'élimination de la couche sacrificielle (112) et la gravure de la couche de masque minéral (110), on prévoit une étape de lithographie supplémentaire pour protéger le masque dans des régions supplémentaires autres que les emplacements des espaceurs.

10. Procédé selon la revendication 9, **caractérisé en ce que** l'étape de lithographie supplémentaire utilise une couche sensible à un faisceau électronique qui a une épaisseur inférieure ou égale à la hauteur des espaceurs.

## Patentansprüche

1. Lithografisches Verfahren zum Herstellen von zwei Netzwerken von übereinander liegenden Leitern in einem Substrat, die durch eine Isolierschicht (108) getrennt sind, mit leitenden Durchkontaktierungen (Va, Vb) in der Isolierschicht, um Leiter des ersten Netzwerks mit den Leitern des zweiten Netzwerks an Stellen zu verbinden, an denen sich diese Leiter kreuzen, wobei das Verfahren Folgendes beinhaltet:
- Bilden von Leitern (102) des ersten Netzwerks auf dem Substrat,
- Absetzen eines Isoliermaterials, das die Leiter des ersten Netzwerks bedeckt und die Isolierschicht (108) bildet,
- Absetzen einer mineralischen Maskenschicht (110) auf dem Isoliermaterial,
- Absetzen einer Opferschicht (112) und Ätzen dieser Schicht gemäß einem ersten Teilmuster,
- Bilden von Abstandshaltern (116) an den Rändern von Elementen der so geätzten Opferschicht, wobei die Abstandshalter Zonen freilassen, die ein zweites Teilmuster definieren,
- Eliminieren der Opferschicht (112), um nur die Abstandshalter zurückzulassen,
- Ätzen der mineralischen Maskenschicht dort, wo sie nicht durch die Abstandshalter geschützt ist, wobei dieses Ätzen die Stellen der Leiter des zweiten Netzes definiert,
- erstes Ätzen des Isoliermaterials in einer ersten Tiefe,
- zweites Ätzen des Isoliermaterials in einer zweiten Tiefe,
- wobei eine der Ätzungen durch die Konfiguration der mineralischen Maske (110) definiert wird und den Stellen der Leiter des zweiten Netzwerks entspricht und die andere Ätzung gleichzeitig durch Öffnungen (122), die in einer durch Lithografie (120) geätzten Schicht gebildet werden, und durch das zweite Teilmuster begrenzt wird, das durch die Abstandshalter (116) definiert wird, wobei die Öffnungen die Stellen von leitenden Durchkontaktierungen definieren und wenigstens an zwei gegenüberliegenden Rändern von Abstandshaltern begrenzt werden,
- Füllen von gekreuzten Regionen in dem Isoliermaterial mit einem Leitermaterial (130) bündig mit der Oberfläche des Materials, ohne über gekreuzte Regionen überzulaufen, wobei dieses Material gleichzeitig die Leiter des zweiten Netzwerks und die leitenden Durchkontaktierungen bildet.

2. Verfahren nach Anspruch 1, **dadurch gekennzeichnet, dass** die durch Lithografie (120) geätzte Schicht vor den beiden Ätzungen des Isoliermaterials abgesetzt wird, sie gemäß einem Öffnungsmuster exponiert wird, wonach die erste Ätzung des Isoliermaterials erfolgt, um die Stellen von leitenden Durchkontaktierungen zu definieren, wobei die durch Lithografie geätzte Schicht eliminiert wird, und die zweite Ätzung dann zum Definieren der Stellen von Leitern des zweiten Netzwerks erfolgt.

3. Verfahren nach Anspruch 2, **dadurch gekennzeichnet, dass** die Abstandshalter vor der zweiten Ätzung eliminiert werden.

4. Verfahren nach Anspruch 1, **dadurch gekennzeichnet, dass** die erste Ätzung des Isoliermaterials nach dem Ätzen der mineralischen Maske erfolgt, um die Stellen von Leitern des zweiten Netzwerks zu definieren, dann die durch Lithografie (120) geätzte Schicht abgesetzt und gemäß einem Öffnungsmuster (122) graviert wird, dann die zweite Ätzung des Isoliermaterials erfolgt, um die Stellen der leitenden Durchkontaktierungen zu definieren, wonach das Harz und die Abstandshalter eliminiert werden.

5. Verfahren nach einem der Ansprüche 1 bis 4, **dadurch gekennzeichnet, dass** die durch Lithografie geätzte Schicht ein Harz ist, das für ionische oder elektronische oder photonische Strahlung empfindlich ist, und ihre Dicke geringer als die Höhe der Abstandshalter ist.

6. Verfahren nach Anspruch 5, **dadurch gekennzeichnet, dass** die durch Lithografie geätzte Schicht durch Stapeln einer für ionische oder elektronische oder photonische Strahlung nicht empfindlichen Schicht und einer für ionische oder elektronische oder photonische Strahlung empfindlichen Schicht zusammengesetzt ist, wobei die nicht empfindliche Schicht eine Dicke hat, die geringer ist als die Höhe der Abstandshalter.

7. Verfahren nach einem der Ansprüche 1 bis 6, **dadurch gekennzeichnet, dass** das Isoliermaterial ein dielektrisches Material mit geringer Dielektrizitätskonstante ist, das auf einer Siliciumscheibe abgesetzt ist.

8. Verfahren nach einem der Ansprüche 1 bis 7, **dadurch gekennzeichnet, dass** das Leitermaterial (130) Kupfer ist, das mit der Oberfläche des Isoliermaterials bündig ist, ohne über gekreuzte Regionen überzulaufen.

9. Verfahren nach einem der Ansprüche 1 bis 8, **dadurch gekennzeichnet, dass** zwischen dem Schritt des Eliminierens der Opferschicht (112) und dem Ätzen der mineralischen Maskenschicht (110) ein ergänzender lithografischer Schicht zum Schützen der Maske in den ergänzenden Regionen außer an den Stellen der Abstandshalter vorgesehen ist.

10. Verfahren nach Anspruch 9, **dadurch gekennzeichnet, dass** der ergänzende lithografische Schritt eine für einen elektronischen Strahl empfindliche Schicht nutzt, die eine Dicke hat, die gleich oder geringer als die Höhe der Abstandshalter ist.

## Claims

1. A lithographic method for forming in a substrate two superposed networks of conductors separated by an insulating layer (108), with conducting vias (Va, Vb) in the insulating layer for connecting conductors of the first network to the conductors of the second network at locations where these conductors cross one another, the method comprising:
- the formation of the conductors (102) of the first network on the substrate,
- the deposition of an insulating material covering the conductors of the first network and forming the insulating layer (108),
- the deposition of a mineral mask layer (110) onto the insulating material,
- the deposition of a sacrificial layer (112) and the etching of this layer according to a first partial pattern,
- the formation of spacers (116) on the edges of the elements of the sacrificial layer thus etched, the spacers leaving free regions defining a second partial pattern,
- the elimination of the sacrificial layer (112) so as to leave only the spacers remaining,
- the etching of the mineral mask layer at the places where it is not protected by the spacers, this etching defining the locations of the conductors of the second network,
- a first etching of the insulating material down to a first depth,
- a second etching of the insulating material down to a second depth,
- one of the etchings being defined by the configuration of the mineral mask (110) and corresponding to the locations of the conductors of the second network, and the other etching being bounded both by openings (122) formed in a layer etched by lithography (120) and by the second partial pattern defined by the spacers (116), the openings defining the locations of conducting vias and being bounded on at least two opposing edges by spacers,
- the filling of the regions etched into the insulating material by a conductive material (130) flush with the surface of the material without overspilling from the regions etched away, this material forming both the conductors of the second network and the conducting vias.

2. The method as claimed in claim 1, **characterized in that** the layer etched by lithography (120) is deposited prior to the two etchings of the insulating material, it is exposed according to a pattern of openings, following which the first etching of the insulating material is carried out for defining the locations of conducting vias, the layer etched by lithography is eliminated, and the second etching is carried out for defining the locations of conductors of the second network.

3. The method as claimed in claim 2, **characterized in that** the spacers are eliminated prior to the second etching.

4. The method as claimed in claim 1, **characterized in that** the first etching of the insulating material is carried out after the etching of the mineral mask for defining the locations of the conductors of the second network, then the layer etched by lithography (120) is deposited and etched according to a pattern of openings (122), then the second etching of the insulating material is carried out for defining the locations of the conducting vias, following which the photoresist and the spacers are eliminated.

5. The method as claimed in one of claims 1 to 4, **characterized in that** the layer etched by lithography is a photoresist sensitive to ion or electron or photon radiation and its thickness is less than the height of the spacers.

6. The method as claimed in claim 5, **characterized in that** the layer etched by lithography is composed of the superposition of a layer which is not sensitive to an ionic or electronic or photonic irradiation and of a layer which is sensitive to an ionic or electronic or photonic irradiation, the non-sensitive layer having a thickness less than the height of the spacers.

7. The method as claimed in one of claims 1 to 6, **characterized in that** the insulating material is a dielectric material with a low dielectric constant deposited onto a silicon wafer.

8. The method as claimed in one of claims 1 to 7, **characterized in that** the conductive material (130) is copper and is flush with the surface of the insulating material without overspilling from the regions etched away.

9. The method as claimed in one of claims 1 to 8, **characterized in that**, between the step for elimination of the sacrificial layer (112) and the etching of the mineral mask layer (110), an additional lithography step is provided in order to protect the mask in additional regions other than the locations of the spacers.

10. The method as claimed in claim 9, **characterized in that** the additional lithography step uses a layer sensitive to an electron beam which has a thickness less than or equal to the height of the spacers.
